(19) Europäisches Patentamt / European Patent Office / Office européen des brevets

(11) **EP 4 254 067 A1**

(12) **EUROPEAN PATENT APPLICATION**


(43) Date of publication:
**04.10.2023 Bulletin 2023/40**

(21) Application number: **23165718.0**

(22) Date of filing: **30.03.2023**

(51) International Patent Classification (IPC):
***G03F 7/027*** *(2006.01)* ***G03F 7/20*** *(2006.01)*
***G03F 7/033*** *(2006.01)*

(52) Cooperative Patent Classification (CPC):
**G03F 7/033; G03F 7/027; G03F 7/202**

(84) Designated Contracting States:
**AL AT BE BG CH CY CZ DE DK EE ES FI FR GB GR HR HU IE IS IT LI LT LU LV MC ME MK MT NL NO PL PT RO RS SE SI SK SM TR**
Designated Extension States:
**BA**
Designated Validation States:
**KH MA MD TN**

(30) Priority: **01.04.2022 US 202263326544 P**



(71) Applicant: **DuPont Electronics, Inc.**
**Wilmington, DE 19805 (US)**

(72) Inventors:
- **LUNGU, Adrian**
  **NJ, 08857 (US)**
- **HACKLER, A Mark**
  **NJ, 07712-3343 (US)**
- **LUNGU, Violeta**
  **NJ, 08857 (US)**

(74) Representative: **Dehns**
**St. Bride's House**
**10 Salisbury Square**
**London EC4Y 8JD (GB)**


(54) **A PRINTING FORM PRECURSOR AND PRINTING FORM THEREOF**


(57) The invention pertains to a printing form precursor, and particularly a printing form precursor that can form printing forms, or printing plates, having improved properties. The printing form precursor includes a photopolymerizable composition containing an additive having a structure of Formula (I). The presence of the additive results in ease of processing and/or better cleanout and reduction in webmarkings on solid areas of the printing form.

Formula (I):

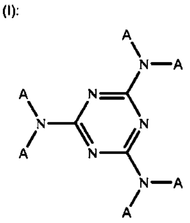

(I)

Each A is independently $-R^1-OR^2$ or $R^3$; each $R^1$ is independently $-CR^4R^5-$; each $R^2$ is independently $C_1-C_6$ alkyl or $C_1-C_4$ alkyl substituted by $C_1-C_4$ alkyl; each $R^3$ is independently H or $C_1-C_6$ alkyl; and each $R^4$ and $R^5$ are independently H or $C_1-C_6$ alkyl.


EP 4 254 067 A1

## Description

### BACKGROUND OF THE INVENTION

This invention pertains to a printing form precursor, and particularly a printing form precursor that can form printing forms, or printing plates, having improved properties.

Flexographic printing plates are widely used for printing of packaging materials ranging from corrugated carton boxes to card boxes and to continuous web of plastic films. Flexographic printing plates can be prepared from photopolymerizable compositions, such as those described in U.S. Pat. Nos. 4,323,637 and 4,427,759. The photopolymerizable compositions generally comprise an elastomeric binder, at least one monomer and a photoinitiator. Photosensitive elements generally have a layer of the photopolymerizable composition interposed between a support and a coversheet or a multilayer cover element. Flexographic printing plates are characterized by their ability to crosslink or cure upon exposure to actinic radiation. Typically, the plate is uniformly exposed through the backside of the plate to a specified amount of actinic radiation. Next, an imagewise exposure of the front-side of the plate is made through an image-bearing artwork or a template, such as a photographic negative, transparency, or phototool (e.g., silver halide films) for so called analog workflow, or through an in-situ mask having radiation opaque areas that had been previously formed above the photopolymerizable layer for so called digital workflow. The plate is exposed to actinic radiation, such as an ultraviolet (UV) or black light. The actinic radiation enters the photosensitive material through the clear areas of the transparency and is blocked from entering the black or opaque areas. The exposed material crosslinks and becomes insoluble to solvents used during image development. The unexposed, uncrosslinked photopolymer areas under the opaque regions of the transparency remain soluble and are washed away with a suitable solvent leaving a relief image suitable for printing. Then, the plate is dried. The printing plate can be further treated to remove surface tackiness. After all desired processing steps, the plate is mounted on a cylinder and used for printing.

Alternatively, a "dry" thermal development process may be used. In a thermal development process, the photosensitive layer, which has been imagewise exposed to actinic radiation, is contacted with an absorbent material at a temperature sufficient to cause the composition in the unexposed portions of the photosensitive layer to soften or melt and flow into an absorbent material. See, for example, U.S. Pat. Nos. 3,264,103 (Cohen et al.); U.S. Pat. No. 5,015,556 (Martens); U.S. Pat. No. 5,175,072 (Martens); U.S. Pat. No. 5,215,859 (Martens); and U.S. Pat. No. 5,279,697 (Peterson et al.). The exposed portions of the photosensitive layer remain hard, that is, do not soften or melt, at the softening temperature for the unexposed portions. The absorbent material collects the softened un-irradiated material and is then separated and/or removed from the photosensitive layer. The cycle of heating and contacting the photosensitive layer may need to be repeated several times in order to sufficiently remove the flowable composition from the unirradiated areas and form a relief structure suitable for printing. Thus what remains is a raised relief structure of irradiated, hardened composition that represents the desired printing image. During a thermal development process, an effective removal of the flowable uncrosslinked material in the unexposed portions of the photosensitive layer is required.

Additionally, it is often desirable for the flexographic relief printing form to print images, particularly solid areas, with uniform, dense coverage of ink, so-called solid ink density. Poor transfer or laydown of ink from the printing form to the substrate, especially in large areas, results in print defects, such as mottle and graininess. Unsatisfactory printing results are especially obtained with solvent-based printing inks, and with UV-curable printing inks.

Solid screening is a well-known process for improving the solid ink density in flexographic printing. Solid screening consists of creating a pattern in the solid printing areas of the relief printing form which is small enough that the pattern is not reproduced in the printing process (i.e., printed image), and large enough that the pattern is substantially different from the normal, i.e., unscreened, printing surface. A pattern of small features that is used for solid screening is often referred to as a plate cell pattern or a microcell pattern.

Various microcell patterns are widely used to improve the capability of relief printing forms to print solids with uniform, dense coverage of ink, i.e., solid ink density. See, for example, Samworth in U.S. Patent Nos. 6,492,095 and 7,580,154, Stolt et al. in U.S. Patent Publication 2010/0143841, and Blomquist et al. in U.S. Patent Application Publication No. 2016/0355004. The microcell patterns may be used in solid areas to improve printed ink density, as well as for text, line work, halftones, that is, any type of image element where an improvement in ink transfer characteristics is realized.

A need exists for a relief printing form derived from a thermal development process that can meet the increasing demands for print quality requiring improved cleanout between raised relief structures, or midtone dots, and to print, particularly solid areas, with uniform, dense coverage of ink. It is also desirable for a printing form to hold microcell patterns with minimum formation of webmarks so as to improve print quality. The present disclosure satisfies this need by providing a printing form precursor containing an additive in the photopolymerizable composition.

### SUMMARY

The invention provides a printing form precursor comprising a photopolymerizable layer, wherein said

photopolymerizable layer comprises a binder, a monomer, a photoinitiator, and an additive; wherein said additive comprises one or more compounds having a structure of Formula (I):

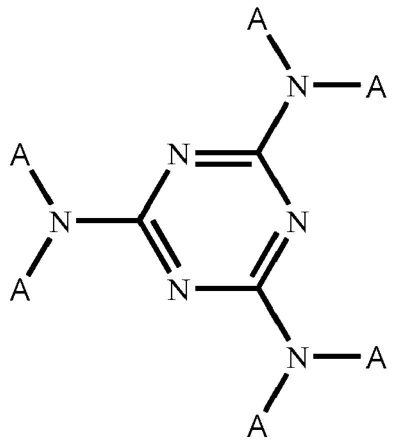

(I) ;

wherein each A is independently $-R^1-OR^2$ or $R^3$; each $R^1$ is independently $-CR^4R^5-$; each $R^2$ is independently $C_1-C_6$ alkyl or $C_1-C_4$ alkyl substituted by $C_1-C_4$ alkyl; each $R^3$ is independently H or $C_1-C_6$ alkyl; and each $R^4$ and $R^5$ are independently H or $C_1-C_6$ alkyl.

An embodiment of the invention provides that the printing form precursor further comprises a digital layer that is ablatable by infrared radiation and opaque to non-infrared actinic radiation.

Another embodiment provides that each A is $-R^1-OR^2$.

Another embodiment provides that each $R^1$ is $-CR^4R^5-$.

Another embodiment provides that at least one $R^2$ is $C_1-C_4$ alkyl.

Another embodiment provides that each $R^4$ and $R^5$ are H.

Another embodiment provides that each $R^2$ is $C_1-C_4$ alkyl.

Another embodiment provides that at least one $R^2$ is $C_1$ alkyl.

Another embodiment provides that each $R^2$ is $C_1$ alkyl.

Another embodiment provides that at least one A is $R^3$.

Another embodiment provides that each A is $R^3$.

Another embodiment provides that at least one $R^3$ is $C_1-C_4$ alkyl.

Yet another embodiment provides that each $R^3$ is $C_1-C_4$ alkyl.

These and other features and advantages of the present invention will be more readily understood by those of ordinary skill in the art from a reading of the following Detailed Description. Certain features of the invention which are, for clarity, described above and below as a separate embodiment, may also be provided in combination in a single embodiment. Conversely, various features of the invention that are described in the context of a single embodiment, may also be provided separately or in any subcombination.

## DESCRIPTION OF THE DRAWINGS

Figure 1 shows microscope images of flexographic plates formed from formulations A1 and A2 having 50% cleanout between the dots.

Figure 2 shows microscope images of the microcell patterns resulting from relief image elements formed from formulations A1 and A2.

Figure 3 shows microscope images of flexographic plates formed from formulations A3 and A4 having 50% cleanout between the dots.

Figure 4 shows microscope images of the microcell patterns resulting from relief image elements formed from formulations A3 and A4.

Figure 5 shows microscope images of flexographic plates formed from formulations A5 and A6 having 50% cleanout between the dots.

Figure 6 shows microscope images of the microcell patterns resulting from relief image elements formed from formulations A5 and A6.

Figure 7 shows microscope images of flexographic plates formed from formulations A7 and A8 having 50% cleanout between the dots.

Figure 8 shows microscope images of the microcell patterns resulting from relief image elements formed from formulations A7 and A8.

Figure 9 shows microscope images of flexographic plates formed from formulations A9 and A10 having 50% cleanout between the dots.

## DETAIL DESCRIPTION

Throughout the following detailed description, similar reference characters refer to similar elements in all figures of the drawings.

Unless otherwise indicated, the following terms as used herein have the meaning as defined below.

"Actinic radiation" refers to radiation capable of initiating reaction or reactions to change the physical or chemical characteristics of a photosensitive composition.

"Dots per inch" (DPI) is a frequency of dot structures in a tonal image, and is a measure of spatial printing dot density, and in particular the number of individual dots that can be placed within the span of one linear inch (2.54 cm). The DPI value tends to correlate with image resolution. Typical DPI range for graphics applications: 75 to 150, but can be as high as 300.

"Line screen resolution", which may sometimes be referred to as "screen ruling" is the number of lines or dots per inch on a halftone screen.

"Optical Density" or simply "Density" is the degree of darkness (light absorption or opacity) of an image, and can be determined from the following relationship:

$$\text{Density} = \log_{10} \{1 / \text{reflectance}\}$$

where reflectance is {intensity of reflected light / intensity of incident light}. Density is commonly calculated in conformance with ISO 5/3:2009 International Standard for Photography and graphic technology-- Density measurements - Part 3: Spectral conditions.

"Solid ink Density" is a measure of the density of a printed area meant to display the maximum amount of print color.

"Graininess" refers to the variation in density of print areas. The ISO-13660 International Print Quality Standard defines it as, "Aperiodic fluctuations of density at a spatial frequency greater than 0.4 cycles per millimeter in all directions." The ISO-13660 metric of graininess is the standard deviation of density of a number of small areas that are 42 $\mu$m square.

"Microcells" refer to image elements or microcells that alter a print surface, which can appear as dimples and/or very tiny reverses, and that are each smaller in at least one dimension than the spacing between smallest periodic structures on the printing form that results from the photosensitive element of the present invention. The microcells are irregularities on a print surface of the relief printing form that are designed to improve the uniformity and apparent density of ink printed on a substrate by the relief printing form. In some embodiments, microcells of the relief printing form can correspond with features of the printed microcell pattern that is integrated into the present photosensitive element.

"Microcell pattern" refers to a composite of image elements or microcells that together form a pattern that alters a print surface of a relief printing form which results from the photosensitive element of the present invention.

"Cleanout" refers to the extent a printing form is free of uncrosslinked, or unpolymerized, plate materials in the entire printing form including areas between raised relief structures, or midtone dots, after contacted by a nonwoven absorbent material in a thermal processor.

"Visible radiation or light" refers to a range of electromagnetic radiation that can be detected by the human eye, in which the range of wavelengths of radiation is between about 390 and about 770 nm.

"Infrared radiation or light" refers to wavelengths of radiation between about 770 and $10^6$ nm.

"Ultraviolet radiation or light" refers to wavelengths of radiation between about 10 and 390 nm.

Note that the provided ranges of wavelengths for infrared, visible, and ultraviolet are general guides and that there may be some overlap of radiation wavelengths between what is generally considered ultraviolet radiation and visible radiation, and between what is generally considered visible radiation and infrared radiation.

"White light" refers to light that contains all the wavelengths of visible light at approximately equal intensities, as in sunlight.

"Room light" refers to light that provides general illumination for a room. Room light may or may not contain all the wavelengths of visible light.

The term "photosensitive" encompasses any system in which the photosensitive composition is capable of initiating a reaction or reactions, particularly photochemical reactions, upon response to actinic radiation. Upon exposure to actinic radiation, chain propagated polymerization of a monomer and/or oligomer is induced by either a condensation mechanism or by free radical addition polymerization. While all photopolymerizable mechanisms are contemplated, the compositions and processes of this invention will be described in the context of free-radical initiated addition polymerization of monomers and/or oligomers having one or more terminal ethylenically unsaturated groups. In this context, the photoinitiator system when exposed to actinic radiation can act as a source of free radicals needed to initiate polymerization of the monomer and/or oligomer. The monomer may have non-terminal ethylenically unsaturated groups, and/or the composition may contain one or more other components, such as a binder or oligomer, that promote crosslinking. As such, the term "photopolymerizable" is intended to encompass systems that are photopolymerizable, photocrosslinkable, or both. As used herein, photopolymerization may also be referred to as curing. The photosensitive element may also be referred to herein as a photosensitive precursor, photosensitive printing precursor, printing precursor, and precursor.

As used herein, the term "solid" refers to the physical state of the photosensitive layer that has a definite volume and shape and resists forces that tend to alter its volume or shape. The layer of the photopolymerizable composition is solid at room temperature, which is a temperature between about 5° C and about 30°C. A solid layer of the photopolymerizable composition may be polymerized (photohardened), or unpolymerized, or both.

The term "digital layer" encompasses a layer that is responsive or alterable by laser radiation, particularly infrared laser radiation, and more particularly is ablatable by infrared laser radiation. The digital layer is also opaque to non-infrared actinic radiation. The digital layer may also be referred to herein as an infrared-sensitive layer, an infrared-sensitive ablation layer, a laser ablatable layer, or an actinic radiation opaque layer.

Unless otherwise indicated, the terms "photosensitive element", "printing form precursor", "printing precursor", and "printing form" encompass elements or structures in any form suitable as precursors for printing, including, but not limited to, flat sheets, plates, seamless continuous forms, cylindrical forms, plates-on-sleeves, and plates-on-carriers.

Additive

An additive containing one or more compounds having a structure of Formula (I), as described above, is introduced into the photopolymerizable layer of a printing form precursor. The presence of this additive was surprisingly found to improve the cleanout of the resulting printing form without compromising other desirable properties for the printing form. While it is possible to adjust other ingredients in the photopolymerizable layer, such as the binder and monomer, to improve the cleanout of the resulting printing form, doing so compromises other desirable properties leading to poor webmarks, inability to hold microcell patterns, loss of highlight dots, etc. The inclusion of the additive allows a high concentration of binder that results in greater strength and durability of the printing form, in addition to achieving good cleanout. The additive is present at an amount ranging typically from 0.5 wt% to 20 wt%, and preferably from 1.5 wt% to 15 wt% based on the total weight of the photopolymerizable layer.

Photosensitive Element

The photosensitive element is a photopolymerizable printing form precursor. The photosensitive element includes a layer of a composition sensitive to actinic radiation which in most embodiments is a composition that is photopolymerizable. The photosensitive element is compatible with common analog and digital workflows or their variations including laminations of masking layers.

The photosensitive element can include a layer of the photosensitive composition and a digital layer adjacent to the photosensitive layer. The digital layer is employed in digital direct-to-plate image technology in which laser radiation, typically infrared laser radiation, is used to form a mask of the image for the photosensitive element (instead of the conventional image transparency or phototool). The digital layer comprises an infrared ablation layer that is ablatable by infrared radiation and opaque to non-infrared actinic radiation. The infrared ablation layer comprises (i) at least one infrared absorbing material; and (ii) a radiation opaque material, wherein (i) and (ii) can be the same or different.

In some embodiments, the photosensitive element initially includes the digital layer disposed above and covers or substantially covers the entire surface of the photopolymerizable layer. In some embodiments, the infrared laser radiation imagewise removes, i.e., ablates or vaporizes, the digital layer to form the in-situ mask. Suitable materials and structures for this actinic radiation opaque layer are disclosed by Fan in U.S. Patent No. 5,262,275; Fan in U.S. Patent No. 5,719,009; Fan in U.S. Patent No. 6,558,876; Fan in EP 0741330A1; and Van Zoeren in U.S. Patent Nos. 5,506,086 and 5,705,310. A material capture sheet adjacent the digital layer may be present during laser exposure to capture the material of the digital layer as it is removed from the photosensitive element as disclosed by Van Zoeren in U.S. Patent No. 5,705,310. Only the portions of the digital layer that were not removed from the photosensitive element will remain on the element forming the in-situ mask.

Materials constituting the digital layer and structures incorporating the digital layer are not particularly limited, provided that the digital layer can be imagewise exposed to form the in-situ mask on or adjacent the photopolymerizable layer of the photosensitive element. The digital layer may substantially cover the surface or only cover an imageable portion of the photopolymerizable layer. The digital layer can be used with or without a barrier layer. If used with the barrier layer, the barrier layer is disposed between the photopolymerizable layer and the digital layer to minimize migration of materials between the photopolymerizable layer and the digital layer. Monomers and plasticizers can migrate over time if they are compatible with the materials in an adjacent layer, which can alter the laser radiation sensitivity of the digital layer or can cause smearing and tackifying of the digital layer after imaging. The digital layer is also sensitive to laser radiation that can selectively remove or transfer digital layer.

In some embodiments, the digital layer comprises a radiation-opaque material, an infrared-absorbing material, and an optional binder. Dark inorganic pigments, such as carbon black and graphite, mixtures of pigments, metals, and metal alloys generally function as both infrared-sensitive material and radiation-opaque material. The optional binder is a polymeric material which includes, but is not limited to, self-oxidizing polymers, non-self-oxidizing polymers, thermochemically decomposable polymers, polymers and copolymers of butadiene and isoprene with styrene and/or olefins, pyrolyzable polymers, amphoteric interpolymers, polyethylene wax, materials conventionally used as the release layer described above, and combinations thereof. The thickness of the digital layer should be in a range to optimize both sensitivity and opacity, which is generally from about 20 Angstroms to about 50 micrometers. The digital layer should have a transmission optical density of greater than 2.0 in order to effectively block actinic radiation and the polymerization of the underlying photopolymerizable layer.

The digital layer includes (i) at least one infrared absorbing material, (ii) a radiation opaque material, wherein (i) and (ii) can be the same or different, and (iii) at least one binder. The following materials are suitable as the binder for the digital layer and include, but not limited to, polyamides, polyethylene oxide, polypropylene oxide, ethylcellulose, hydroxyethyl cellulose, cellulose acetate butyrate, ethylene-propylene-diene terpolymers, copolymers of ethylene and vinyl acetate, copolymers of vinyl acetate and vinyl alcohol, copolymers of vinyl acetate and pyrrolidone, polyvinyl acetate, polyethylene wax, polyacetal, polybutyral, polyalkylene, polycarbonates, polyester elastomer, copolymers of vinyl chloride and vinyl acetate, copolymers of styrene and butadiene, copolymers of styrene and isoprene, thermoplastic block copolymers of styrene and butadiene, thermoplastic block copolymers of styrene and isoprene, polyisobutylene, polybutadiene, polycholorprene, butyl rubber, nitrile rubber, thermoplastic polyurethane elastomer, cyclic rubbers, copolymers of vinylacetate and (meth)acrylate, acrylonitrile-butadiene-styrene terpolymer, methacrylate-butadiene-styrene terpolymer, alkyl methacrylate polymer or copolymer, copolymers of styrene and maleic anhydride, copolymers of styrene and maleic anhydride partially esterified with alcohols, and combinations thereof. Preferred binders include polyamides, polyethylene oxide, polypropylene oxide, ethylcellulose, hydroxyethyl cellulose, cellulose acetate butyrate, ethylene-propylene-diene terpolymers, copolymers of ethylene and vinyl acetate, copolymers of vinyl acetate and vinyl alcohol, copolymers of vinyl acetate and pyrrolidone, polyvinyl acetate, polyethylene wax, polyacetal, polybutyral, polyalkylene, polycarbonates, cyclic rubber, copolymer of styrene and maleic anhydride, copolymer of styrene and maleic anhydride partially esterified with alcohol, polyester elastomers, and combinations thereof.

Materials suitable for use as the radiation opaque material and the infrared absorbing material include, but is not limited to, metals, metal alloys, pigments, carbon black, graphite and combinations thereof. Mixtures of pigments in which each pigment functions as the infrared absorbing material, or the radiation opaque material (or both) can be used with the binder. Dyes are also suitable as infrared absorbing agents. Examples of suitable dyes include poly(substituted)phthalocyanine compounds; cyanine dyes; squarylium dyes; chalcogenopyrloarylidene dyes; bis(chalcogenopyrylo)-polymethine dyes; oxyindolizine dyes; bis(aminoaryl)-polymethine dyes; merocyanine dyes; croconium dyes; metal thiolate dyes; and quinoid dyes. Preferred are carbon black, graphite, metal, and metal alloys that function as both the infrared absorbing material and the radiation opaque material. The radiation opaque material and the infrared absorbing material may be in dispersion to facilitate handling and uniform distribution of the material.

The photopolymerizable layer is formed of a composition comprising at least a binder, a plasticizer, a photoinitiator, and the additive of Formula (I) described above. Preferred plasticizers are typically in liquid form, and include polybutadiene oil, polyisoprene oil, and white mineral oil. These oils have number average molecular weights ranging from 1,000 to 30,000, and vinyl contents ranging from 0 to 85 %. These oils are available from commercial sources or can be readily prepared by one skilled in the art following known methods. The photoinitiator is sensitive to actinic radiation. Throughout this specification actinic radiation will include ultraviolet radiation and/or visible light. The solid layer of the photopolymerizable composition is treated with one or more solutions and/or heat to form a relief suitable for relief printing. As used herein, the term "solid" refers to the physical state of the layer which has a definite volume and shape and resists forces that tend to alter its volume or shape. A solid layer of the photopolymerizable composition may be polymerized (photohardened), or unpolymerized, or both. In some embodiments, the layer of the photopolymerizable composition is elastomeric. In one embodiment, the photosensitive element includes a layer of photopolymerizable composition composed at least of a binder, at least one ethylenically unsaturated compound, and a photoinitiator. In another embodiment, the layer of the photopolymerizable composition includes an elastomeric binder, at least one ethylenically unsaturated compound, and a photoinitiator. In some embodiments, the relief printing form is an elastomeric printing form (i.e., the photopolymerizable layer is an elastomeric layer).

The binder can be a single polymer or mixture of polymers. In some embodiments, the binder is an elastomeric binder. In other embodiments, the layer of the photopolymerizable composition is elastomeric. Binders include natural or synthetic polymers of conjugated diolefin hydrocarbons, including polyisoprene, 1,2-polybutadiene, 1,4-polybutadiene, butadiene/acrylonitrile, and diene/styrene thermoplastic-elastomeric block copolymers. Preferably, the elastomeric block copolymer is an A-B-A type block copolymer of different structures such as linear, and multi-arm, and A-B type block copolymer, where A represents a non-elastomeric block, preferably a vinyl polymer and most preferably polystyrene, and B represents an elastomeric block, preferably polybutadiene or polyisoprene. In some embodiments, the elastomeric A-B-A block copolymer binders can be poly(styrene/isoprene/styrene) block copolymers, poly(styrene/butadiene/styrene) block copolymers, and combinations thereof. The binder is present in an amount of about 10% to 90% by weight of the photosensitive composition. In some embodiments, the binder is present at about 40% to 85% by weight of the photosensitive composition.

Other suitable binders include acrylics; polyvinyl alcohol; polyvinyl cinnamate; polyamides; epoxies; polyimides; styrenic block copolymers; nitrile rubbers; nitrile elastomers; non-crosslinked polybutadiene; non-crosslinked polyisoprene; polyisobutylene and other butyl elastomers; polyalkyleneoxides; polyphosphazenes; elastomeric polymers and copolymers of acrylates and methacrylate; elastomeric polyurethanes and polyesters; elastomeric polymers and copolymers of olefins such as ethylene-propylene copolymers and non-crosslinked EPDM; elastomeric copolymers of vinyl acetate and its partially hydrogenated derivatives.

The photopolymerizable composition may contain at least one compound capable of addition polymerization that is compatible with the binder to the extent that a clear, non-cloudy photosensitive layer is produced. The at least one compound capable of addition polymerization may also be referred to as a monomer and can be a single monomer or mixture of monomers. Monomers

that can be used in the photopolymerizable composition are well known in the art and include, but are not limited to, addition-polymerization ethylenically unsaturated compounds with at least one terminal ethylenic group. Monomers can be appropriately selected by one skilled in the art to provide elastomeric property to the photopolymerizable composition.

The photoinitiator can be any single compound or combination of compounds which is sensitive to actinic radiation, generating free radicals which initiate the polymerization of the monomer or monomers without excessive termination. Any of the known classes of photoinitiators, particularly free radical photoinitiators may be used. Alternatively, the photoinitiator may be a mixture of compounds in which one of the compounds provides the free radicals when caused to do so by a sensitizer activated by radiation. In most embodiments, the photoinitiator for the main exposure (as well as post-exposure and backflash) is sensitive to visible or ultraviolet radiation, between 310 to 400 nm, and preferably 345 to 365 nm. Photoinitiators are generally present in amounts from 0.001% to 10.0% based on the weight of the photopolymerizable composition.

The photopolymerizable composition can contain other additives depending on the final properties desired. Additional additives to the photopolymerizable composition include sensitizers, plasticizers, rheology modifiers, thermal polymerization inhibitors, colorants, processing aids, antioxidants, antiozonants, stabilizers, dyes, and fillers.

The stabilizers include phenolic antioxidants such as BNX1035, and BNX1037; phosphite antioxidants such as tris(4-nonylphenyl) phosphite (TNPP), Benefos 1618, and Benefos 1626; hindered amine light stabilizers such as BLS292, and BLS123; thioethers such as Irganox® 565, and Irganox® 1520L; cyano acrylates such as Uvinul 3039; and other types of stabilizers commonly known in the art.

The thickness of the photopolymerizable layer can vary over a wide range depending upon the type of printing plate desired, for example, from about 0.005 inches to about 0.250 inches or greater (about 0.013 cm to about 0.64 cm or greater). In some embodiments, the photopolymerizable layer has a thickness from about 0.005 inch to 0.0450 inch (0.013 cm to 0.114 cm). In some other embodiments, the photopolymerization layer has a thickness from about 0.020 inches to about 0.112 inches (about 0.05 cm to about 0.28 cm). In other embodiments, the photopolymerizable layer has a thickness from about 0.112 inches to about 0.250 inches or greater (0.28 cm to about 0.64 cm or greater). As is conventional in the art, manufacturers typically identify the printing precursors relative to the total thickness of the printing form on press, which includes the thickness of the support and the photopolymerizable layer. The thickness of the photopolymerizable layer for the printing form is typically less than the manufacturer's designated thickness since the thickness of the support is not included.

The photosensitive element can include one or more additional layers on or adjacent the photosensitive layer. In most embodiments the one or more additional layers are on a side of the photosensitive layer opposite the support. Examples of additional layers include, but are not limited to, a protective layer, a capping layer, an elastomeric layer, a barrier layer, and combinations thereof. The one or more additional layers can be removable, in whole or in part, during one of the steps to convert the element into a printing form, such as treating.

Optionally, the photosensitive element may include an elastomeric capping layer on the at least one photopolymerizable layer. The elastomeric capping layer is typically part of a multilayer cover element that becomes part of the photosensitive printing element during calendering of the photopolymerizable layer. Multilayer cover elements and compositions suitable as the elastomeric capping layer are disclosed in Gruetzmacher et al., U.S. Patent Nos. 4,427,759 and 4,460,675. In some embodiments, the composition of the elastomeric capping layer includes an elastomeric binder, and optionally a monomer and photoinitiator and other additives, all of which can be the same or different than those used in the bulk photopolymerizable layer. Although the elastomeric capping layer may not necessarily contain photoreactive components, the layer ultimately becomes photosensitive when in contact with the underlying bulk photopolymerizable layer. As such, upon imagewise exposure to actinic radiation, the elastomeric capping layer has cured portions in which polymerization or crosslinking have occurred and uncured portions which remain unpolymerized, i.e., uncrosslinked. Treating causes the unpolymerized portions of the elastomeric capping layer to be removed along with the photopolymerizable layer in order to form the relief surface. The elastomeric capping layer that has been exposed to actinic radiation remains on the surface of the polymerized areas of the photopolymerizable layer and becomes the actual printing surface of the printing plate. In embodiments of the photosensitive element that include the elastomeric capping layer, the cell pattern layer is disposed between the elastomeric capping layer and the digital layer.

For some embodiments of photosensitive elements useful as relief printing forms, the surface of the photopolymerizable layer may be tacky and a release layer having a substantially non-tacky surface can be applied to the surface of the photopolymerizable layer. Such release layer can protect the surface of the photopolymerizable layer from being damaged during removal of an optional temporary coversheet or other digital mask element and can ensure that the photopolymerizable layer does not stick to the coversheet or other digital mask element. During image exposure, the release layer can prevent the digital element with the mask from binding with the photopolymerizable layer. The release layer is insensitive to actinic radiation. The release layer is also suitable as a first embodiment of the barrier layer which is optionally interposed between the photopolymerizable

layer and the digital layer. The elastomeric capping layer may also function as a second embodiment of the barrier layer. Examples of suitable materials for the release layer are well known in the art, and include polyamides, polyvinyl alcohol, hydroxyalkyl cellulose, copolymers of ethylene and vinyl acetate, amphoteric interpolymers, and combinations thereof.

The photosensitive printing element may also include a temporary coversheet on top of an uppermost layer of the element, which may be removed prior to preparation of the printing form. One purpose of the coversheet is to protect the uppermost layer of the photosensitive printing element during storage and handling. Examples of suitable materials for the coversheet include thin films of polystyrene, polyethylene, polypropylene, polycarbonate, fluoropolymers, polyamide or polyesters, which can be subbed with release layers. The coversheet is preferably prepared from polyester, such as Mylar® polyethylene terephthalate film.

## Process to Make Photosensitive Element

It is well within the skill of the practitioner in the art to make or manufacture a photosensitive element printing form precursor that includes a layer of the photopolymerizable composition formed by admixing the binder, oil, monomer, photoinitiator, and other optional additives. In most embodiments, the photopolymerizable mixture is formed into a hot melt, extruded, calendered at temperatures above room temperature to the desired thickness between two sheets, such as the support and the temporary coversheet having the digital layer, or between one flat sheet and a release roll. Alternately, the photopolymerizable material can be extruded and/or calendered to form a layer onto a temporary support and later laminated to the desired final support or to a digital coversheet. The printing form precursor can also be prepared by compounding the components in a suitable mixing device and then pressing the material into the desired shape in a suitable mold. The material is generally pressed between the support and the coversheet. The molding step can involve pressure and/or heat.

The photosensitive element can include one photopolymerizable layer that is of a bi- or multi- layer construction. Further, the photosensitive element may include an elastomeric capping layer on the at least one photopolymerizable layer. Multilayer cover elements and compositions suitable as the elastomeric capping layer are disclosed in Gruetzmacher et al., U.S. Patent Nos. 4,427,759 and 4,460,675.

Cylindrically shaped photopolymerizable elements may be prepared by any suitable method. In one embodiment, the cylindrically shaped elements can be formed from a photopolymerizable printing plate that is wrapped on a carrier or cylindrical support, i.e., sleeve, and the ends of the plate mated to form the cylinder shape. The cylindrically shaped photopolymerizable element can also be prepared extrusion and calendering in-the-round according to the method and apparatus disclosed by Cushner et al. in U.S. Patent 5,798,019.

Those skilled in the art, having benefit of the teachings of the present invention as hereinabove set forth, can affect numerous modifications thereto. These modifications are to be construed as being encompassed within the scope of the present invention as set forth in the appended claims.

## EXAMPLES

In the following examples, all percentages are by weight unless otherwise noted.

### Example 1

Two different formulations for flexographic printing form precursors containing a styrenic block copolymer, a polybutadiene oil and a reactive acrylate as an additive were made. In the first printing precursor (A1), a linear aliphatic difunctional acrylate monomer commonly used in flexography was employed as the additive at a concentration of 12 wt%, based on the total weight of the formulation. In the second formulation (A2), 3 wt% of the linear aliphatic difunctional acrylate monomer in A1 was replaced by Cymel® 350, a highly methylated melamine precursor having a structure of Formula (I) described above. All Cymel® products described in the examples bellow were sourced from Allnex ™. Both printing form precursors contained 68 wt% styrene-isoprene-styrene block copolymer, 12 wt% polybutadiene oil with a vinyl content lower than 30%, UV photoinitiators, a dye and stabilizers. Following a typical flexographic platemaking workflow, plates were digitally imaged, crosslinked using 365nm actinic radiation and thermally processed. Microscope images of 50% cleanout between the dots (Fig.1) and of the microcell patterning (Fig.2) were taken for both plates.

### Example 2

Two different formulations for flexographic printing form precursors containing a styrenic block copolymer, a polybutadiene oil and a reactive acrylate were made. In the first printing form precursor formulation (A3), a linear aliphatic difunctional acrylate monomer commonly used in flexography was employed as the additive at a concentration of 12 wt%, based on the total weight of the formulation. In the second printing form precursor (A4), 6 wt% of the linear aliphatic difunctional acrylate monomer in A3 was replaced by 6 wt% of Cymel® 350, a highly methylated melamine precursor having a structure of Formula (I) described above. Both printing form precursors contain 68 wt% styrene-isoprene-styrene block copolymer, 12 wt% polybutadiene oil with a vinyl content higher than 30%, UV photoinitiators, a dye and stabilizers. Plates were processed similarly to the ones from Example 1. Microscope images of 50% cleanout

between the dots and microcell patterning for both plates are shown in Fig. 3 and Fig. 4, respectively.

Example 3

Two different formulations for flexographic printing form precursors containing a styrenic block copolymer, a polybutadiene oil and a reactive acrylate were made. In the first printing form precursor formulation (A5), a linear aliphatic difunctional acrylate monomer commonly used in flexography was employed as the additive at a concentration of 10.5 wt%, based on the total weight of the formulation. In the second printing form precursor (A6), 16% of linear aliphatic difunctional acrylate monomer in A5 was replaced by a highly butylated melamine precursor having a structure of Formula (I) as described above. Consequently, printing form precursor A5 contains 10.5 wt% of aliphatic diacrylate and printing form precursor A6 contains 9 wt% of aliphatic diacrylate and 1.5 wt% of Cymel® 1156. Both printing form precursors contain 71 wt% styrene-isoprene-styrene block copolymer, 10.5 wt% polybutadiene oil with a vinyl content higher than 30%, UV photoinitiators, a dye and stabilizers. The plates were processed as the ones from the previous 2 examples. Microscope images of 50% cleanout between the dots and microcell patterning for both plates are shown in Fig. 5 and Fig. 6, respectively.

Example 4

Two different formulations for flexographic printing form precursors containing a styrenic block copolymer, a polybutadiene oil and a reactive acrylate were made. In the first printing form precursor formulation (A7), a linear aliphatic difunctional acrylate monomer commonly used in flexography was employed as the additive at a concentration of 12 wt%, based on the total weight of the formulation. In the second printing form precursor (A8), 25% of linear aliphatic difunctional acrylate monomer in A7 was replaced by a methylated butylated melamine precursor having a structure of Formula (I) as described above. Consequently, formulation A7 contains 12 wt% of aliphatic diacrylate, and formulation A8 contains 9 wt% of aliphatic diacrylate and 3 wt% of the Cymel® 1133. Both printing form precursors contain 68 wt% styrene-isoprene-styrene block copolymer, 12 wt% polybutadiene oil with a vinyl content higher than 30%, UV photoinitiators, a dye and stabilizers. Both printing precursors were processed as the ones from the previous examples. Microscope images of 50% cleanout between the dots and of microcell patterning for both plates are shown in Fig. 7 and Fig. 8, respectively.

Example 5

Two flexographic printing precursors were made similar to the ones in Example 4, where the styrene-isoprene-styrene block copolymer was replaced by styrene-butadiene-styrene block copolymer. One printing precursor contains a linear aliphatic difunctional acrylate monomer (identical to the one from previous four examples) (A9), and in the second one (A10), 25% of the aliphatic diacrylate was replaced by a methylated butylated melamine precursor having a structure of Formula (I) as described above. Printing form precursor A9 contains 12 wt% of aliphatic diacrylate and printing form precursor A10 contains 9 wt% of aliphatic diacrylate and 3 wt% of Cymel® 1133. Both printing form precursors contain 64 wt% styrene-butadiene-styrene block copolymer, 16 wt% polybutadiene oil with a vinyl content higher than 30%, UV photoinitiators, a dye and stabilizers. The printing form precursors were processed as the ones from the previous examples. Microscope images of 50% cleanout between the dots are shown for both plates in Fig. 9.

Prophetic Examples

Flexographic printing form precursors based on styrene-isoprene-styrene (SIS) or styrene-butadiene-styrene (SBS), or combination of both block copolymers SIS and SBS that contain highly methylated melamine precursors having a structure of Formula (I) presented above, at any level between 1.5 wt% and 6 wt%, show improvement in the cleanout between the dots in a thermally processed plate. The term 'cleanout' refers to the ability of the nonwoven used in the thermal processor to remove the unpolymerized plate material from the areas between the dots. For example, a printing form precursor containing 35 wt% of a SIS and 35 wt% of an SBS binder and 3 wt% of a highly methoxylated melamine precursor will show an improved cleanout when compared with a flexo printing form precursor that has only an aliphatic difunctional acrylate monomer.

**Claims**

1. A printing form precursor comprising a photopolymerizable layer, wherein said photopolymerizable layer comprises a binder, a monomer, a photoinitiator, and an additive; wherein said additive comprises one or more compounds having a structure of Formula (I):

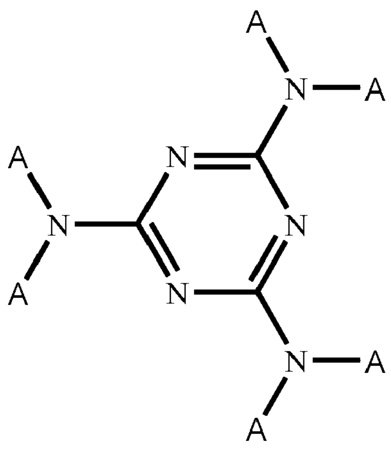

(I) ;

wherein each A is independently $-R^1-OR^2$ or $R^3$; each $R^1$ is independently $-CR^4R^5-$; each $R^2$ is independently $C_1$-$C_6$ alkyl or $C_1$-$C_4$ alkyl substituted by $C_1$-$C_4$ alkyl; each $R^3$ is independently H or $C_1$-$C_6$ alkyl; and each $R^4$ and $R^5$ are independently H or $C_1$-$C_6$ alkyl.

**2.** The printing form precursor of claim 1 further comprising a digital layer that is ablatable by infrared radiation and opaque to non-infrared actinic radiation.

**3.** The printing form precursor of claim 1 or 2, wherein each A is $-R^1-OR^2$ .

**4.** The printing form precursor of any preceding claim, wherein at least one $R^2$ is $C_1$-$C_4$ alkyl.

**5.** The printing form precursor of claim 4, wherein each $R^2$ is $C_1$-$C_4$ alkyl.

**6.** The printing form precursor of any preceding claim, wherein each $R^4$ and $R^5$ are H.

**7.** The printing form precursor of any preceding claim, wherein at least one $R^2$ is $C_1$ alkyl.

**8.** The printing form precursor of claim 7, wherein each $R^2$ is $C_1$ alkyl.

**9.** The printing form precursor of claim 1 or 2, wherein at least one A is $R^3$.

**10.** The printing form precursor of claim 9, wherein each A is $R^3$.

**11.** The printing form precursor of claim 9 or 10, wherein at least one $R^3$ is $C_1$-$C_4$ alkyl.

**12.** The printing form precursor of claim 11, wherein each $R^3$ is $C_1$-$C_4$ alkyl.

A1 A2

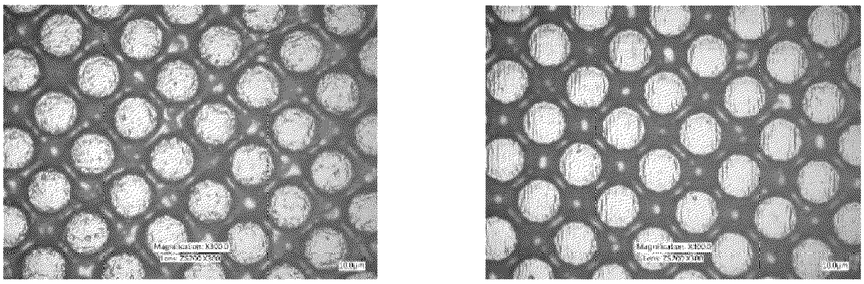

Fig. 1

A1 A2

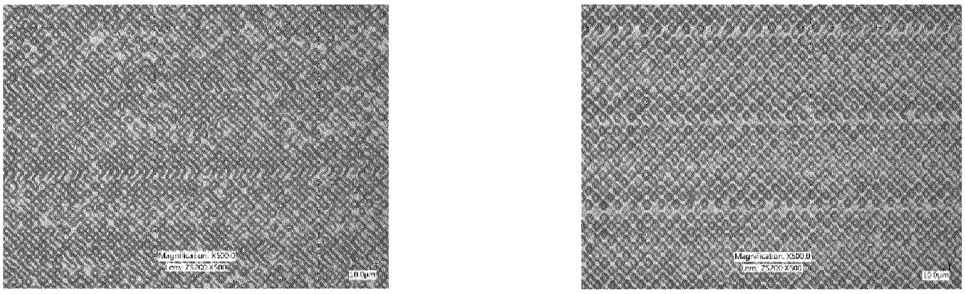

Fig. 2

A3 A4

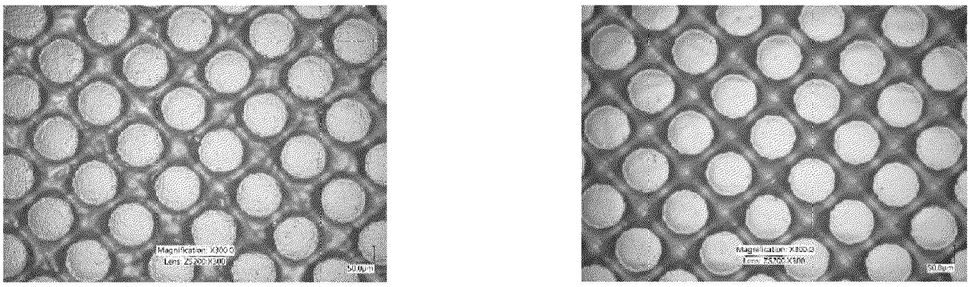

Fig. 3

A3 A4

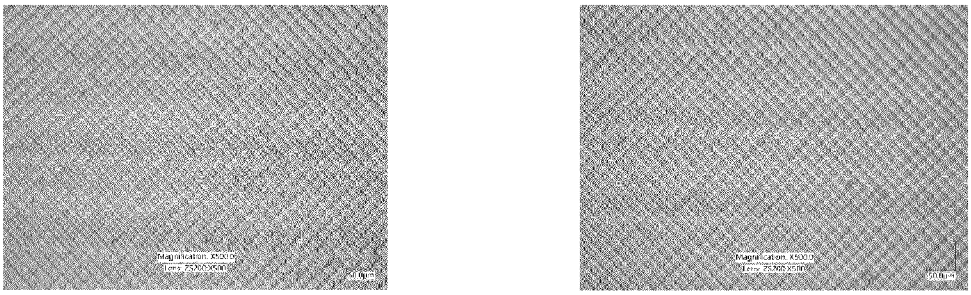

Fig. 4

A5 A6

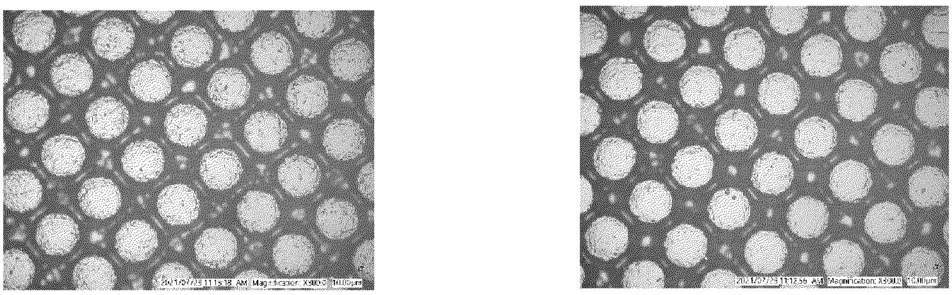

Fig. 5

A5 A6

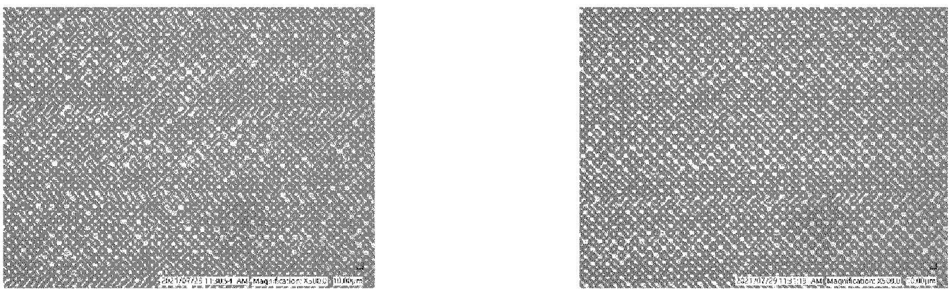

Fig. 6

A7 A8

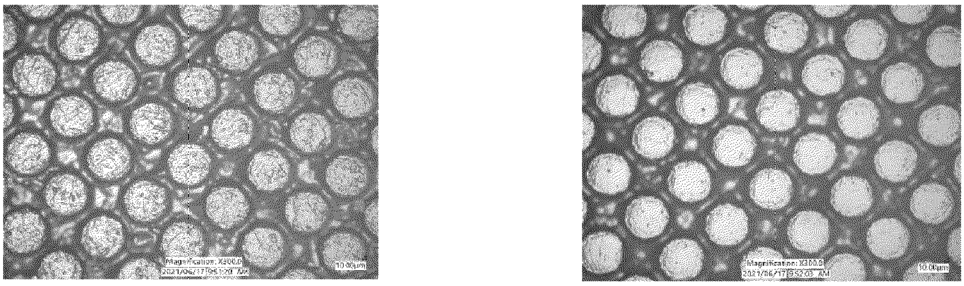

**Fig. 7**

A7 A8

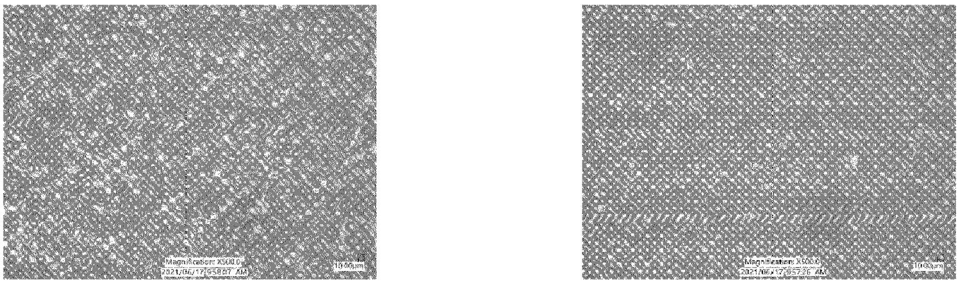

**Fig. 8**

A9 A10

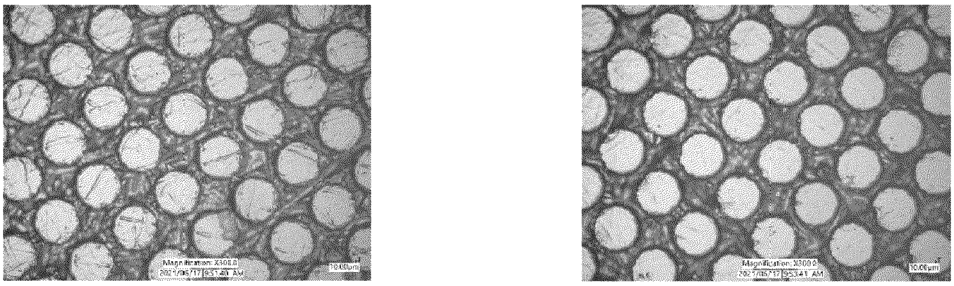

**Fig. 9**

Europäisches Patentamt
European Patent Office
Office européen des brevets

# EUROPEAN SEARCH REPORT

Application Number
EP 23 16 5718

## DOCUMENTS CONSIDERED TO BE RELEVANT

| Category | Citation of document with indication, where appropriate, of relevant passages | Relevant to claim | CLASSIFICATION OF THE APPLICATION (IPC) |
|---|---|---|---|
| X | US 2008/063980 A1 (LUNGU ADRIAN [US]) 13 March 2008 (2008-03-13) | 1,3-8 | INV. G03F7/027 G03F7/20 G03F7/033 |
| Y | * the whole document * | 2,9-12 | |
| | ----- | | |
| Y | US 2016/355004 A1 (BLOMQUIST ROBERT M [US] ET AL) 8 December 2016 (2016-12-08) | 2 | |
| A | * claims * * para. [0003] * | 1,3-12 | |
| | ----- | | |
| Y | US 2004/034115 A1 (BAUDIN GISELE [CH] ET AL) 19 February 2004 (2004-02-19) | 9,10 | |
| A | * para. [0144]-[0147], [0203], [0249] * | 1,3-8, 11,12 | |
| | ----- | | |
| Y | EP 2 197 840 B1 (BASF SE [DE]) 6 November 2013 (2013-11-06) | 9-12 | |
| A | * para. [0146], [0147], [0175], [0176] * | 1,3-8 | |
| | ----- | | |
| Y | US 2009/061364 A1 (TENG GARY GANGHUI [US]) 5 March 2009 (2009-03-05) | 9-12 | |
| A | * para. [0002], [0033]-[0052] * | 1,3-8 | TECHNICAL FIELDS SEARCHED (IPC) |
| | ----- | | G03F |

The present search report has been drawn up for all claims

1

| Place of search | Date of completion of the search | Examiner |
|---|---|---|
| Munich | 29 August 2023 | Borowczak, Baptiste |

CATEGORY OF CITED DOCUMENTS

X : particularly relevant if taken alone
Y : particularly relevant if combined with another document of the same category
A : technological background
O : non-written disclosure
P : intermediate document

T : theory or principle underlying the invention
E : earlier patent document, but published on, or after the filing date
D : document cited in the application
L : document cited for other reasons
& : member of the same patent family, corresponding document

EPO FORM 1503 03.82 (P04C01)

## ANNEX TO THE EUROPEAN SEARCH REPORT ON EUROPEAN PATENT APPLICATION NO.

EP 23 16 5718

This annex lists the patent family members relating to the patent documents cited in the above-mentioned European search report.
The members are as contained in the European Patent Office EDP file on
The European Patent Office is in no way liable for these particulars which are merely given for the purpose of information.

29-08-2023

| Patent document cited in search report | Publication date | Patent family member(s) | Publication date |
|---|---|---|---|
| US 2008063980 A1 | 13-03-2008 | EP 1873588 A2 | 02-01-2008 |
| | | JP 5124182 B2 | 23-01-2013 |
| | | JP 2008070861 A | 27-03-2008 |
| | | US 2008063980 A1 | 13-03-2008 |
| | | US 2010136483 A1 | 03-06-2010 |
| | | US 2012015294 A1 | 19-01-2012 |
| US 2016355004 A1 | 08-12-2016 | CN 107850857 A | 27-03-2018 |
| | | EP 3304206 A2 | 11-04-2018 |
| | | JP 6901410 B2 | 14-07-2021 |
| | | JP 2018517939 A | 05-07-2018 |
| | | KR 20180014757 A | 09-02-2018 |
| | | US 2016355004 A1 | 08-12-2016 |
| | | US 2020254749 A1 | 13-08-2020 |
| | | US 2023001684 A1 | 05-01-2023 |
| | | WO 2016196257 A2 | 08-12-2016 |
| US 2004034115 A1 | 19-02-2004 | AT 409708 T | 15-10-2008 |
| | | AU 3455102 A | 24-06-2002 |
| | | EP 1341823 A1 | 10-09-2003 |
| | | JP 4021767 B2 | 12-12-2007 |
| | | JP 2004515611 A | 27-05-2004 |
| | | US 2004034115 A1 | 19-02-2004 |
| | | WO 0248202 A1 | 20-06-2002 |
| EP 2197840 B1 | 06-11-2013 | CN 101952248 A | 19-01-2011 |
| | | EP 2197840 A1 | 23-06-2010 |
| | | JP 5473921 B2 | 16-04-2014 |
| | | JP 2011500525 A | 06-01-2011 |
| | | KR 20100074261 A | 01-07-2010 |
| | | TW 200925144 A | 16-06-2009 |
| | | US 2010297542 A1 | 25-11-2010 |
| | | WO 2009047151 A1 | 16-04-2009 |
| US 2009061364 A1 | 05-03-2009 | NONE | |

EPO FORM P0459

For more details about this annex : see Official Journal of the European Patent Office, No. 12/82

## REFERENCES CITED IN THE DESCRIPTION

*This list of references cited by the applicant is for the reader's convenience only. It does not form part of the European patent document. Even though great care has been taken in compiling the references, errors or omissions cannot be excluded and the EPO disclaims all liability in this regard.*

### Patent documents cited in the description


- US 4323637 A
- US 4427759 A
- US 3264103 A, Cohen
- US 5015556 A, Martens
- US 5175072 A, Martens
- US 5215859 A, Martens
- US 5279697 A, Peterson
- US 6492095 B
- US 7580154 B, Stolt
- US 20100143841 A, Blomquist
- US 20160355004
- US 5262275 A, Fan
- US 5719009 A, Fan
- US 6558876 B, Fan
- EP 0741330 A1, Fan
- US 5506086 A, Van Zoeren
- US 5705310 A
- US 4460675 A
- US 5798019 A, Cushner